# EUROPÄISCHE PATENTANMELDUNG

(11) **EP 4 586 281 A1**
(43) Veröffentlichungstag der Anmeldung: **16.07.2025**
(21) Anmeldenummer: 25315016.3
(22) Anmeldetag: 15.01.2025
(51) Int. Cl.: H01B 7/08, H05K 1/02

(54) **GESCHIRMTE FLEXIBLE FLACHBANDLEITUNG**

(30) Priorität: 15.01.2024 DE 102024101089
(71) Anmelder: Nexans, 92400 Courbevoie (FR)
(72) Erfinder: Hoehne, Armin, 92400 Courbevoie (FR); Döllinger, Ulrich, 92400 Courbevoie (FR); Steinberg, Helmut, 92400 COURBEVOIE (FR); Schröer, Frank, 92400 Courbevoie (FR)
(74) Vertreter: Ipsilon

(57) **Zusammenfassung**

Es wird ein Verfahren zur Herstellung einer geschirmten Flachbandleitung für höhere Leistungen beschrieben. Die Flachbandleitung weist neben in mehreren übereinanderliegenden Schichten angeordneten Leitungen für Gleich- oder Wechselströme zuoberst und zuunterst Schirmflächen sowie seitlich verlaufende Schirmleitungen in den Ebenen auf.

## Beschreibung

### Gebiet

Die vorliegende Erfindung betrifft flexible Flachbandleitungen, d.h. Leitungen, welche eine oder mehrere auf einen flexiblen Träger aus isolierendem Material aufgebrachte Leiterbahnen aufweisen. Diese Leitungen sind auch unter den Bezeichnungen Folienkabel, Flat-Flex-Kabel oder Flexible Flat Cable (FFC) bekannt. Im Folgenden werden diese Bezeichnungen synonym verwendet.

### Hintergrund

Folienkabel werden insbesondere dort eingesetzt, wo der Einbauraum für andere Kabelarten nicht ausreicht, besonders wenn eine Vielzahl von Leitungen parallel zu einem Ende des Kabels geführt werden.

Für Datenleitungen, über welche Daten mit hohen Übertragungsraten geführt werden, und die gegenüber elektromagnetischen Störungen abgeschirmt werden sollen, müssen entsprechende Abschirmungen vorgesehen werden, welche an einem oder beiden Enden eines Kabels mit einem Bezugspotential verbunden werden, in der Regel mit einem Erd- oder Massepotential.

Bei bekannten geschirmten FFCs wird nach dem Laminieren des eigentlichen FFC eine Schirmschicht um das FFC herumgewickelt, bspw. in Form eines metallisierten Kunststofffilms. Dieses nachträgliche Aufbringen ist vergleichsweise aufwendig und erfordert zusätzliche Produktionsschritte.

Aus der Offenlegungsschrift US 2021/0166836 A1 ist ein geschirmtes FFC bekannt, bei dem zwei parallel zueinander verlaufende Signalleitungen zwischen zwei parallel zu den Signalleitungen verlaufenden Schirmleitungen angeordnet sind. Die Schirmleitungen weisen entlang der Längserstreckung des FFC freiliegende Bereiche auf. An der Ober- und Unterseite des FFC sind Schirmflächen angeordnet, welche jeweils mit freiliegenden Bereichen der Schirmleitungen elektrisch leitend verbunden sind.

Die bekannten FFC weisen nur eine einzelne Lage für Signalleitungen auf, wodurch die darüber übertragbare Leistung selbst bei vergleichsweise breit ausgeführten Leiterbahnen beschränkt ist. Insbesondere in Anwendungen, bei denen große Ströme hochfrequent gepulst fließen, können die Vorteile von geschirmten FFC bislang nicht genutzt werden.

Es ist daher eine Aufgabe der vorliegenden Erfindung, ein Verfahren zur Herstellung eines geschirmten FFCs für höhere Leistungen vorzuschlagen.

### Beschreibung der Erfindung

Diese Aufgabe wird durch das in Anspruch 1 angegebene Verfahren gelöst. Weitere Ausgestaltungen und Weiterentwicklungen des Verfahrens sind in den abhängigen Ansprüchen angegeben.

Ein Verfahren zur Herstellung einer geschirmten flexiblen Flachbandleitung mit einer ersten Länge und einer ersten Breite gemäß einem ersten Aspekt der Erfindung umfasst das Bereitstellen mindestens zweier elektrisch isolierender Trägerschichten gleicher Länge und Breite. Auf einer Oberfläche jeder der mindestens zwei Trägerschichten ist mindestens eine Leiterbahn aufgebracht. Das Verfahren umfasst ferner das deckungsgleiche Übereinanderschichten und mechanische Verbinden der mindestens zwei Trägerschichten mit den darauf aufgebrachten Leiterbahnen. Die mechanische Verbindung ist dazu ausgelegt, dass zumindest eine Trennung bzw. Delaminierung der Schichten verhindert wird. Eine geringfügige Verschiebung der Schichten zueinander kann möglich oder sogar erwünscht sein. Die mechanische Verbindung der Schichten kann durch Kleben, partielles Verschmelzen der Schichten oder in geeigneter Form ineinandergreifende Strukturen erfolgen. Das Verfahren umfasst außerdem das Aufbringen einer Isolierungsschicht auf die mindestens eine Leiterbahn der zuoberst liegenden Trägerschicht, wobei die Isolierungsschicht sich über eine zweite Länge erstreckt, die kürzer ist als die erste Länge, und wobei die Enden der Isolierungsschicht von den jeweiligen Enden der Trägerschicht beabstandet sind, so dass die mindestens eine Leiterbahn an den jeweiligen Enden zur elektrischen Kontaktierung zugänglich ist. Ferner umfasst das Verfahren das Aufbringen einer geschlossenen ersten Schirmfläche auf die zuoberst liegende Isolierungsschicht. Die erste Schirmfläche erstreckt sich in Richtung der Breite der Flachbandleitung mindestens über alle Leiterbahnen, und in Richtung der Länge der Flachbandleitung über eine dritte Länge, welche kürzer ist als die erste Länge. Vorzugsweise ist die dritte Länge so lang wie die zweite Länge, oder nur geringfügig kürzer. Analog wird eine geschlossene zweite Schirmfläche unterhalb der zuunterst liegenden Trägerschicht aufgebracht. Die zweite Schirmfläche erstreckt sich in Richtung der Breite der Flachbandleitung mindestens über alle Leiterbahnen, und in Richtung der Länge der Flachbandleitung über eine vierte Länge. Die vierte Länge kann der dritten Länge entsprechen, kürzer oder länger als diese sein, jedoch ist sie nicht länger als die erste Länge. Die erste Schirmfläche und die darunter liegende Isolierschicht sind so zu den Trägerschichten ausgerichtet, dass Leiterbahnen an beiden Enden der Trägerschichten elektrisch kontaktierbar sind. Alternativ ist die erste Schirmfläche und die darunter liegende Isolierschicht so zu den Trägerschichten ausgerichtet ist, dass eine oder mehrere Leiterbahnen an einem Ende der Trägerschichten elektrisch kontaktierbar sind, und die zweite Schirmfläche ist so zu dem anderen Ende der Trägerschichten ausgerichtet ist, dass eine oder mehrere Leiterbahnen an dem anderen Ende der Trägerschichten elektrisch kontaktierbar sind. Bei beiden Alternativen wird so sichergestellt, dass die eine oder mehreren Leiterbahnen der mindestens zwei Trägerschichten an keinem Ende der Flachbandleitung von beiden Schirmflächen zugleich vollständig überdeckt sind, und ein elektrischer Anschluss möglich ist.

Bei einer Ausgestaltung des Verfahrens werden eine oder mehrere elektrisch isolierende Trägerschichten bereitgestellt, wobei auf zwei gegenüberliegenden Oberflächen mindestens einer der Trägerschichten jeweils mindestens eine Leiterbahn aufgebracht ist. Bei dieser Ausgestaltung umfasst das Verfahren außerdem das Aufbringen einer Isolierschicht zwischen denjenigen Trägerschichten, welche einander gegenüberliegende Leiterbahnen aufweisen, bzw. zwischen der zuunterst liegenden Trägerschicht und der untenliegenden Schirmfläche, sofern diese zuunterst liegende Trägerschicht der Schirmfläche zugewandte Leiterbahnen aufweist. Das Anbringen einer Isolierschicht kann entfallen, wenn durch die Führung der Leiterbahnen sichergestellt ist, dass sich im gestapelten Zustand nur Leiterbahnen berühren können, die gleiche Potentiale und/oder identische Ströme gleicher Fließrichtung führen.

Bei einer oder mehreren Ausgestaltungen umfasst das Verfahren außerdem das elektrische Verbinden der ersten und der zweiten Schirmfläche zumindest an einem Ende der Flachbandleitung.

Bei einer oder mehreren Ausgestaltungen des Verfahrens werden eine oder mehrere einer elektrisch isolierenden Trägerschichten bereitgestellt, wobei auf mindestens einer der Trägerschichten mindestens drei Leiterbahnen vorgesehen sind, von denen mindestens eine nahe an und entlang einer der längsseitigen Kanten der Trägerschicht verläuft. Nahe an der Kante verlaufen kann einen Abstand von wenigen Millimetern umfassen, wobei Vorzugsweise der Abstand kleiner ist als 1 mm. Bei dieser Ausgestaltung umfasst das Verfahren außerdem das elektrische Kontaktieren der ersten und/oder der zweiten Schirmfläche mit zumindest jeweils einer der mindestens einen nahe an der längsseitigen Kante verlaufenden Leiterbahn. Das elektrische Verbinden erfolgt zumindest an einem Ende der Schirmfläche, kann aber auch an beiden Enden erfolgen, und/oder an einer oder mehreren beliebigen Stellen.

Die mit dem vorstehend beschriebenen Verfahren hergestellten FFCs können neben der Verwendung als Datenleitungen auch als geschirmte Leitungen für die Energieversorgung von elektrischen oder elektronischen Bauteilen oder Baugruppen verwendet werden. Hierzu kann die Breite des FFCs vergrößert und mehrere Leiterlagen können übereinander gestapelt werden. Dabei kann bspw. bei "zweiadrigen" FFCs durch geeignete Zuweisung von Lagen eine zumindest teilweise Aufhebung von elektromagnetischen Abstrahlungen durch den Stromfluss erreicht werden. Dies kann z.B. dann der Fall sein, wenn Hin- und Rückleitung einer FFC-Stromversorgungsleitung jeweils abwechselnd übereinander angeordnet sind. So kann auch bei Stromversorgungsleitungen, über welche hochfrequent geschaltete Ströme fließen, die elektromagnetische Abstrahlung reduziert werden.

Um die Schirmwirkung zu verbessern können neben der Verbindung der äußeren Schirmschichten nur an den jeweiligen Enden auch weitere Verbindungen der Schirmschichten und ggf. der an der Kante der Trägerschicht verlaufenden Beilauf- oder Schirmleitungen vorgesehen sein.

### Kurze Beschreibung der Zeichnung

Im folgenden Abschnitt wird die Erfindung mit Bezug auf die Zeichnung näher erläutert. In der Zeichnung zeigt
Fig. 1 eine Explosionszeichnung einer ersten Ausgestaltung einer erfindungsgemäßen flexiblen Flachbandleitung,
Fig. 2 eine Explosionszeichnung einer zweiten Ausgestaltung einer erfindungsgemäßen flexiblen Flachbandleitung,
Fig. 3 eine Explosionszeichnung einer dritten Ausgestaltung einer erfindungsgemäßen flexiblen Flachbandleitung, und
Fig. 4 eine Explosionszeichnung einer vierten Ausgestaltung einer erfindungsgemäßen flexiblen Flachbandleitung.

In den Figuren können gleiche oder ähnliche Elemente mit denselben Bezugszeichen referenziert sein.

### Beschreibung von Ausführungsbeispielen

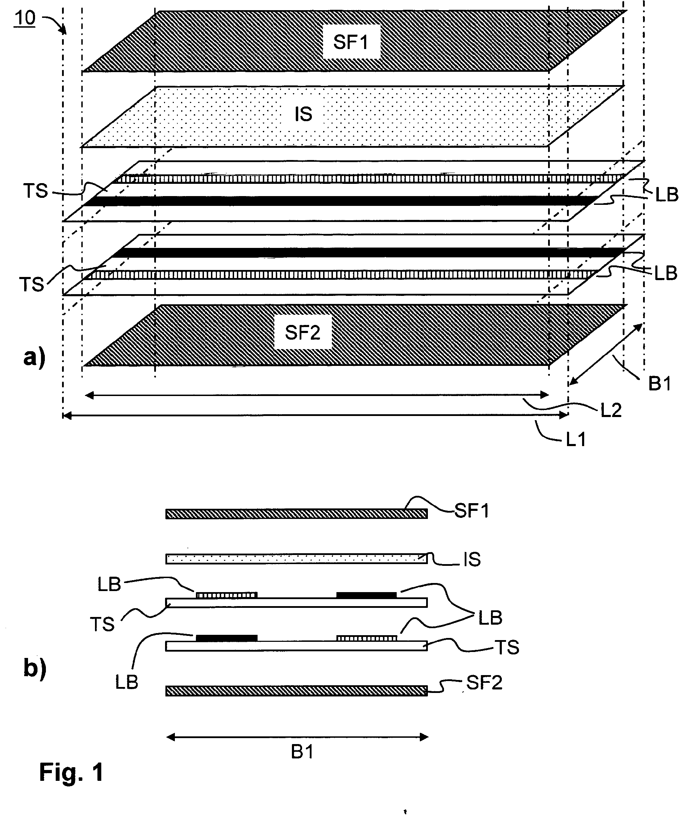

Figur 1 zeigt eine Explosionszeichnung einer ersten Ausgestaltung einer erfindungsgemäßen flexiblen Flachbandleitung 10. Dabei zeigt Figur 1 a) eine perspektivische Darstellung, und Figur 1 b) eine Schnittdarstellung. Zwei Trägerschichten TS mit jeweils auf einer Seite aufgebrachten Leiterbahnen LB sind übereinander angeordnet. Die Leiterbahnen LB sind lediglich beispielhaft dargestellt und können breiter ausgeführt sein als in der Figur dargestellt. Die Leiterbahnen LB in der Figur sind beispielsweise für eine Gleichspannungs-Stromversorgung vorgesehen und umfassen eine Leiterbahn für die positive Versorgungsspannung, hier in schwarz dargestellt, und eine Leiterbahn für die negative Versorgungsspannung oder Masse, hier mit der vertikalen Schraffierung dargestellt. Die Leiterbahnen LB können jeweils so angeordnet sein, dass sich die durch den fließenden Strom hervorgerufenen Magnetfelder zumindest teilweise gegenseitig aufheben. Hier sind dazu jeweils eine schwarze Leiterbahn und eine vertikal schraffierte Leiterbahn direkt übereinander angeordnet. Oberhalb und unterhalb der beiden Trägerschichten TS ist jeweils eine durchgehende Schirmfläche SF1 bzw. SF2 angeordnet. Eine zwischen der oberen Trägerschicht und der oberen Schirmfläche SF1 angeordnete Isolierschicht IS verhindert einen elektrischen Kurzschluss zwischen den Leiterbahnen LB und der oberen Schirmfläche SF1. Die Abmessungen der Isolierschicht IS sind mindestens so groß, dass die Leiterbahnen LB abgedeckt sind, ohne dabei jedoch die Möglichkeit einer elektrischen Kontaktierung der Leiterbahnen LB zu beeinträchtigen. Ebenso sind die Abmessungen der Schirmflächen SF1 und SF2 so gewählt, dass ein Anschlussbereich für die Leiterbahnen LB an den Enden der Trägerschichten TS zugänglich bleibt, aber ein elektrischer Kurzschluss mit den Leiterbahnen LB vermieden wird. Dies kann bspw. dadurch erreicht werden, dass die Schirmflächen SF1 und SF2 nicht größer sind als die Isolierschicht. In dieser und den nachfolgenden Figuren sind die unterschiedlichen Abmessungen einzelner Schichten bzw. Flächen durch strichpunktierte Hilfslinien verdeutlicht.

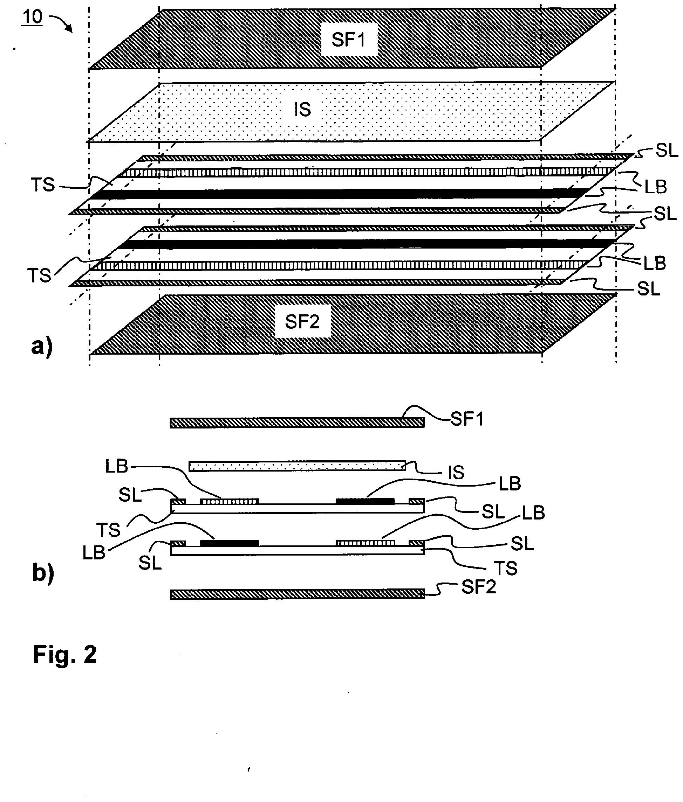

Figur 2 zeigt eine Explosionszeichnung einer zweiten Ausgestaltung einer erfindungsgemäßen flexiblen Flachbandleitung 10, wiederum in einer perspektivischen Darstellung in Figur 2 a) und einer Schnittdarstellung in Figur 2 b). Die zweite Ausgestaltung entspricht im Wesentlichen derjenigen aus Figur 1. Im Unterschied zu der zuvor beschriebenen Ausgestaltung sind an den äußeren Rändern der Trägerschichten Schirmleitungen SL vorgesehen, welche elektrisch mit den Schirmflächen SF1, SF2 verbindbar sind. Die Verbindung kann im Anschlussbereich, d.h., an den Enden der Flachbandleitung, oder auch mittels Durchkontaktierungen oder direkten elektrischen Kontakt an beliebiger Stelle erfolgen. Die Isolierschicht IS kann hierzu, wie in der Figur dargestellt, eine geringere Breite als die Trägerschichten haben, so dass ein direkter elektrischer Kontakt zwischen Schirmleitung SL und Schirmfläche SF möglich ist.

Es sei darauf hingewiesen, dass die Dicken der unterschiedlichen Elemente, anders als in den schematischen Darstellungen der Zeichnung, in allen Ausgestaltungen unterschiedlich sein können. So können die Schirmleitungen bspw. dicker ausgeführt sein als die Leiterbahnen LB, um so einen gewissen Ausgleich der Dicke der Isolierschicht IS herbeizuführen. Auch kann die Isolierschicht IS so ausgeführt sein, dass sich nach deren Aufbringen eine im Wesentlichen plane Oberfläche ergibt.

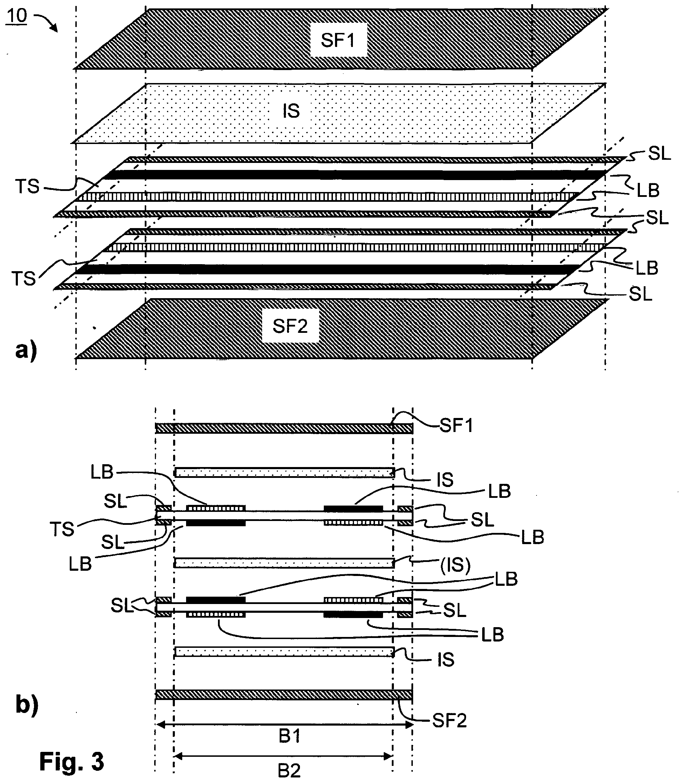

Figur 3 zeigt eine Explosionszeichnung einer dritten Ausgestaltung einer erfindungsgemäßen flexiblen Flachbandleitung 10, wie in den Figuren 1 und 2 in einer perspektivischen Darstellung in Figur 3 a) und einer Schnittdarstellung in Figur 3 b). In dieser Ausgestaltung liegen die Leiterbahnen LB zum größten Teil so, dass sich die durch den fließenden Strom hervorgerufenen Magnetfelder zumindest teilweise gegenseitig aufheben, ähnlich wie unter Figur 1 beschrieben. Bei dieser Ausgestaltung sind dazu an beiden Oberflächen der Trägerschichten TS Leiterbahnen LB aufgebracht. Die Ströme in den unmittelbar übereinander liegenden Leiterbahnen LB fließen dabei vorzugsweise in entgegengesetzte Fließrichtungen und deren Beträge sind vorzugsweise gleich groß. Zwischen den zwei Trägerschichten TS und zwischen den Schirmflächen SF1, SF2 und der daran anliegenden Trägerschicht sind jeweils Isolierschichten IS vorgesehen, um elektrische Kurzschlüsse zu verhindern. Die Isolierschicht IS zwischen den beiden Trägerschichten TS kann ggf. entfallen, wenn die Führung der Leiterbahnen LB dies zulässt, bspw. wenn Leiterbahnen LB mit gleichen Strömen und Flussrichtungen übereinander liegen. In der Figur sind an den Längsseiten der Flachbandleitung 10 wieder Schirmleitungen SL vorgesehen. Diese können beidseitig auf die Trägerschichten TS aufgebracht sein, und die Isolierschichten IS können eine kleinere Breite B2 aufweisen als die Breite B1 der Trägerschichten. Dadurch können die Schirmleitungen SL und die Schirmflächen SF1, SF2 in direkten elektrischen Kontakt miteinander gelangen und die Schirmwirkung verbessern und auch den Anschluss vereinfachen.

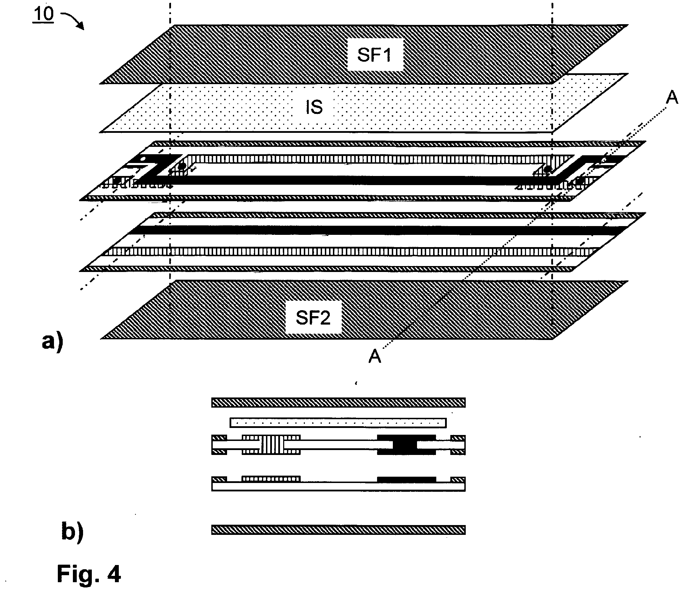

Bei allen Ausgestaltungen der Flachbandleitung kann die Leitungsführung so gestaltet sein, dass die Verbindung von gleichen Potentialen oder Signalen führenden Leitungen benachbarter Trägerschichten mit entsprechenden Anschlüssen vereinfacht ist. Eine beispielhafte Ausgestaltung ist in Figur 4 gezeigt.

Figur 4 zeigt eine Explosionszeichnung einer vierten Ausgestaltung einer erfindungsgemäßen flexiblen Flachbandleitung 10. In Figur 4 a) ist erneut eine perspektivische Darstellung gezeigt, während in Figur 4 b) eine Schnittdarstellung für den Schnitt durch eine Ebene gezeigt ist, in welcher die gepunktete Gerade A-A verläuft. Wie in Figur 4 a) leicht erkennbar ist, wird durch geeignete Seitenwechsel der Leiterbahnen auf einer der Trägerschichten über eine größere Strecke dem durch den Stromfluss erzeugte magnetischen Feld entgegengewirkt, während die Anschlüsse an den Enden der Trägerschichten passend zueinander liegen. Auf die Bezeichnung der einzelnen Elemente wurde in der Figur verzichtet, es wird auf die vorstehend beschriebenen Figuren verwiesen.

### Bezugszeichenliste

- 10: Flachbandleitung
- Bx: Breite
- Lx: Länge
- TS: Trägerschicht
- LB: Leiterbahn
- IS: Isolierschicht
- SFx: Schirmfläche
- SL: Schirmleitung

## Patentansprüche

1. Verfahren zur Herstellung einer geschirmten flexiblen Flachbandleitung (10) mit einer ersten Länge (L1) und einer ersten Breite (B1) umfassend:
- Bereitstellen mindestens zweier elektrisch isolierender Trägerschichten (TS) gleicher Länge und Breite, wobei auf einer Oberfläche jeder der mindestens zwei Trägerschichten (TS) mindestens eine Leiterbahn (LB) aufgebracht ist, und
- deckungsgleiches Übereinanderschichten (130) und mechanisches Verbinden der mindestens zwei Trägerschichten (TS) mit den darauf aufgebrachten Leiterbahnen (LB),
- Aufbringen einer Isolierungsschicht (IS) auf die mindestens eine Leiterbahn (LB) der zuoberst liegenden Trägerschicht (TS), wobei die Isolierungsschicht (IS) sich über eine zweite Länge (L2) erstreckt, die kürzer ist als die erste Länge (L1), und wobei die Enden der Isolierungsschicht (IS) von den jeweiligen Enden der Trägerschicht (TS) beabstandet sind, so dass die mindestens eine Leiterbahn (LB) an den jeweiligen Enden zur elektrischen Kontaktierung zugänglich ist,
wobei das Verfahren ferner umfasst:
- Aufbringen einer geschlossenen ersten Schirmfläche (SF1) auf die zuoberst liegende Isolierungsschicht (IS), welche erste Schirmfläche (SF1) sich in Richtung der Breite (B1) der Flachbandleitung (10) mindestens über alle Leiterbahnen (LB) erstreckt, und welche erste Schirmfläche (SF1) sich in Richtung der Länge (L1) der Flachbandleitung (10) über eine dritte Länge (L3) erstreckt, welche kürzer ist als die erste Länge (L1),
- Aufbringen einer geschlossenen zweiten Schirmfläche (SF2) unterhalb der zuunterst liegenden Trägerschicht (TS), welche zweite Schirmfläche (SF2) sich in Richtung der Breite (B1) der Flachbandleitung (10) mindestens über alle Leiterbahnen (LB) erstreckt, und welche sich in Richtung der Länge (L1) der Flachbandleitung (10) über eine vierte Länge (L4) erstreckt, welche nicht länger ist als die erste Länge (L1),
wobei entweder die erste Schirmfläche und die darunter liegende Isolierschicht so zu den Trägerschichten ausgerichtet sind, dass Leiterbahnen (LB) an beiden Enden der Trägerschichten elektrisch kontaktierbar sind, oder wobei die erste Schirmfläche und die darunter liegende Isolierschicht so zu den Trägerschichten ausgerichtet ist, dass eine oder mehrere Leiterbahnen an einem Ende der Trägerschichten elektrisch kontaktierbar sind, und die zweite Schirmfläche so zu dem anderen Ende der Trägerschichten ausgerichtet ist, dass eine oder mehrere Leiterbahnen an dem anderen Ende der Trägerschichten elektrisch kontaktierbar sind, so dass die eine oder mehreren Leiterbahnen (LB) der mindestens zwei Trägerschichten (TS) an keinem Ende der Flachbandleitung (10) von beiden Schirmflächen (SF1, SF2) zugleich vollständig überdeckt sind.

2. Verfahren nach Anspruch 1, außerdem umfassend:
- elektrisches Verbinden der ersten und der zweiten Schirmfläche zumindest an einem Ende der Flachbandleitung (10).

3. Verfahren nach Anspruch 1, wobei mindestens drei Leiterbahnen (LB1, LB2, LB3) auf der mindestens einen Trägerschicht (TS) vorgesehen sind, und wobei das Verfahren außerdem umfasst:
- elektrisches Kontaktieren der ersten und/oder der zweiten Schirmfläche (SF1, SF2) mit zumindest jeweils einer der zuäußerst liegenden Leiterbahnen (LB1, LB3) zumindest an einem Ende der jeweiligen Schirmfläche (SF1, SF2).

4. Nach dem Verfahren eines oder mehrerer der Ansprüche 1 bis 3 hergestellte geschirmte Flachbandleitung (10).
